# EUROPEAN PATENT APPLICATION

(11) **EP 3 636 795 A1**
(43) Date of publication of application: **15.04.2020**
(21) Application number: 18199423.7
(22) Date of filing: 09.10.2018
(51) Int. Cl.: C23C 14/02, C23C 14/06, C23C 14/32, C23C 16/26, C23C 28/04, C23C 28/00, F16J 9/26

(54) **THICK, LOW-STRESS TETRAHEDRAL AMORPHOUS CARBON COATINGS**

(71) Applicant: Nanofilm Technologies International Pte Ltd, Singapore 139959 (SG)
(72) Inventor: The designation of the inventor has not yet been filed
(74) Representative: Schlich, George

(57) **Abstract**

A method of continuously depositing a coating on a substrate comprises
(a) depositing a first layer of ta-C on a substrate via a CVA process, said first layer having a first hardness and a first thickness;
(b) adjusting the parameters of the CVA process and depositing a second layer of ta-C on a substrate via a CVA process, said second layer having a second hardness and a second thickness, and
(c) repeating the above steps to provide a coating comprising at least 5 such first layers and at least 4 such second layers,
wherein the first thickness is greater than the second thickness and the first hardness is greater than the second hardness.

## Description

### Introduction

This present invention relates to an improved method of depositing a tetrahedral amorphous carbon (ta-C) coating on a substrate, to coatings obtainable from these methods and to coated substrates, especially engine components.

### Background to the Invention

A need exists in the art for hard, durable coatings to protect e.g. engine components from wear, prolonged exposure to high temperature, abrasion and other damage that occurs in long term use of such components in working engines.

To achieve this, a large variety of deposition techniques are used to coat substrates. Vapor deposition technology is typically used to form thin film deposition layers in various types of applications, including microelectronic applications and heavy duty applications. Deposition technology can be classified in two main categories. A first is known as Chemical Vapor Deposition (CVD). CVD generally refers to deposition processes occurring due to a chemical reaction. Common examples of CVD processes include electro-deposition, epitaxy and thermal oxidation. A second category of deposition is commonly known as Physical Vapor Deposition (PVD). PVD generally refers to the deposition of solid substances occurring as a result of a physical process.

Amorphous carbon is a free, reactive form of carbon which does not have a crystalline form. Various forms of amorphous carbon films exist and these are usually categorised by the hydrogen content of the film and the sp²:sp³ ratio of the carbon atoms in the film.

In an example of the literature in this field, amorphous carbon films are categorised into 7 categories (see table below taken from "Name Index of Carbon Coatings" from Fraunhofer Institut Schich- und Oberflächentechnik):

| **Amorphous Carbon Films** | | | | | | |
|---|---|---|---|---|---|---|
| Hydrogen-Free | | | Hydrogenated | | | |
| Unmodified | | Modified | Unmodified | | Modified with | |
| | | With metals | | | Metals | Non-metals |
| sp² | sp³ | sp² | sp² or sp³ | sp³ | sp² | sp² |
| Hydrogen-free amorphous carbon | Tetrahedral, hydrogen-free amorphous carbon | Metal-containing, hydrogen-free amorphous carbon | Hydrogenate d amorphous carbon | Tetrahedral, hydrogenate d amorphous carbon | Metal-containing, hydrogenated amorphous carbon | Non-metal containing hydrogenate d amorphous carbon |
| **a-C** | **ta-C** | **a-C:Me** | **a-C:H** | **ta-C:H** | **a-C:H:Me** | **a-C:H:X** |

Tetrahedral hydrogen-free amorphous carbon (ta-C) is characterised in that it contains little or no hydrogen (less than 5%mol, typically less than 2%mol) and a high content of sp³ hybridised carbon atoms (typically greater than 80% of the carbon atoms being in the sp³ state).

Whilst the term "diamond-like carbon" (DLC) is sometimes used to refer to all forms of amorphous carbon materials, the term as used herein refers to amorphous carbon materials other than ta-C. Common methods of DLC manufacture use hydrocarbons (such as acetylene), hence introducing hydrogen into the films (in contrast to ta-C films in which the raw material is typically hydrogen free high purity graphite).

In other words, DLC typically has an sp² carbon content of greater than 50% and/or a hydrogen content of 20%mol and above. The DLC may be undoped or doped with metals or non-metals (see table above).

Hard carbon films can be deposited on the substrate using sputtering techniques, one PVD process, to provide a protective layer over the substrate. Another known PVD technique is cathodic vapor arc deposition methods, in which an electric arc is used to vaporize/sublimate material from a cathode target. Consequently, the resulting vaporized/sublimated material condenses on a substrate to form a thin, harder film or coating.

Although cathodic vapor arc deposition of ta-C coatings onto substrates produces coatings that are harder and stronger than carbon coatings obtained from sputtering, cathodic vapor arc deposition of ta-C coatings has its own share of drawbacks.

Due to the hard nature of ta-C coatings, the internal stresses present within these coatings are high. Thus, it is not practical, for instance, to apply thick, hard layers of ta-C coatings by cathodic vapor arc deposition onto substrates as the large internal stresses within the thick layers of coatings makes the coatings brittle and prone to cracking and breakage. Consequently, only thin layers of ta-C can be appropriately applied to surfaces to increase their hardness. As a result, there is limited application of such coatings.

WO 2009/151404 A1 (Nanofilm Technologies International Pte Ltd) describes a process of depositing a coating on a substrate by depositing material on a substrate using a cathodic vacuum arc (CVA) deposition step, followed by depositing further material using a physical vapour deposition step which does not involve CVA (e.g. sputtering). In WO 2009/151404, the thickness of the layer(s) deposited by CVA are greater than the thickness of the layer(s) deposited by the sputtering method. It is stated that by using a combination of harder layers deposited by CVA and softer layers deposited by sputtering, the coating substantially maintains its overall hardness, but has a reduced stress, rendering the coating usable. This allows for thicker coatings of ta-C coatings to be produced which do not suffer from brittleness and cracking.

The method in WO 2009/151404 uses a two-step process using two different vapour deposition techniques (FCVA and sputtering). Separately, while an advantage generally of ta-C films is their hardness the use of a soft intermediate layer between the harder layers compromises overall film hardness.

There exists a need for further processes for depositing thick ta-C coatings with high hardness but low stress, preferably more efficient processes.

An aim of the present invention is to provide an alternative to the above methods. A further aim of embodiments is to provide alternative, preferably improved, methods of depositing relatively thick and hard but nevertheless relatively low stress ta-C coatings. An aim of specific embodiments is to provide an improved method yielding coatings that can be harder than hitherto whilst remaining similarly low stress e.g. as per known coatings in the art.

### Summary of The Invention

Accordingly, the invention provides a method of depositing a coating on a substrate, the method comprising:
(a) depositing a first layer of ta-C on a substrate via a CVA process, said first layer having a first hardness and a first thickness,
(b) depositing a second layer of ta-C on a substrate via a CVA process, said second layer having a second hardness and a second thickness, and
(c) optionally, repeating step (a) at least once,
wherein the first thickness is greater than the second thickness and the first hardness is greater than the second hardness.

The invention also provides a method of depositing a coating on a substrate, the method comprising:
(a) depositing a first layer of ta-C on a substrate via a CVA process, said process carried out using deposition parameters to deposit a first layer having a first hardness and a first thickness,
(b) adjusting the parameters of the CVA deposition process to deposit onto the first layer a second layer of ta-C having reduced hardness and reduced thickness, and
(c) repeating step (a) at least once.

As described in more detail below in examples, the above methods may comprise briefly adjusting the parameters to deposit the second layer and then reverting substantially to the parameters of step (a) to deposit a further first layer. The method may then be repeated in order to deposit a coating having alternative first and second layers. Hence, the process can comprise mainly deposition as per step (a) and only a shorter time period for the step (b) deposition.

Also provided are substrates coated by the methods and apparatus for carrying out the coating.

### Details of The Invention

As discussed above, the term "tetrahedral amorphous carbon" (ta-C) as used herein refers to amorphous carbon having a low hydrogen content and a low sp² carbon content.

Ta-C is a dense amorphous material described as composed of disordered Csp³, interlinked by strong bonds, similar to those that exist in disordered diamond (see Neuville S, "New application perspective for tetrahedral amorphous carbon coatings", QScience Connect 2014:8, http://dx.doi.org/10.5339/connect.2014.8). Due to its structural similarity with diamond, ta-C also is a very hard material with hardness values often greater than 30 GPa.

For example, the ta-C may have a hydrogen content less than 10%, typically 5% or less, preferably 2% or less (for example 1% or less). The percentage content of hydrogen provided here refers to the molar percentage (rather than the percentage of hydrogen by mass). The ta-C may have an sp² carbon content less than 30%, typically 20% or less, preferably 15% or less. Preferably, the ta-C may have a hydrogen content of 2% or less and an sp² carbon content of 15% or less. The ta-C is preferably not doped with other materials (either metals or non-metals).

By contrast, the term "diamond-like carbon" (DLC) as used herein refers to amorphous carbon other than ta-C. Accordingly, DLC has a greater hydrogen content and a greater sp² carbon content than ta-C. For example, the DLC may have a hydrogen content of 20% or greater, typically 25% or greater, for example 30% or greater. The percentage content of hydrogen provided here again refers to the molar percentage (rather than the percentage of hydrogen by mass). The DLC may have an sp² carbon content of 50% or greater, typically 60% or greater. Typically, the DLC may have a hydrogen content of greater than 20% and an sp² carbon content of greater than 50%. The DLC may be undoped or doped with metals and/or non-metals.

The methods of the invention can advantageously be used to deposit ta-C coatings that are thick and hard and have relatively low stress. The methods generally comprise continuously depositing the coating on the substrate to produce a coating comprising a plurality of first and second layers. Steps (a) and (b) are preferably repeated to yield multilayer coatings. For example, the methods may comprise repeating the deposition steps to provide a coating comprising at least 3, preferably at least 5 such first layers and at least 2, preferably at least 4 such second layers.

Thus, a working coating can be built of from multiple layers. In use, methods typically comprise repeating alternating steps (a) and (b) to form a plurality of ta-C layers. Adjacent ta-C layers of (a) and (b) are made of the same material (carbon) and the (b) layers are, as described below in more detail, thin compared to the (a) layers so examination of the coating as a whole may not, however, reveal discreet layers as a ghost or history of the manufacturing process.

As the harder, first layers deposited in step (a) have a greater thickness than the softer, second layers deposited in step (b), usually significantly so, the overall hardness of the coating is high while the internal stress within the coating is reduced due to the effects of the soft layer.

The terms "hard" and "soft" in relation to the "hard layers" and "soft layers" are relative terms. The hard layers have greater hardness values and greater densities than the soft layers. The hard layers also have a greater Young's modulus than the soft layers. The soft layers are much thinner than and lie between harder layers; they nevertheless are found to advantageously influence the overall film properties. The invention enables deposition of thick coatings with a comparable hardness to the bulk, hard layers without the coatings overly suffering from brittleness or delamination from the substrate. Hardness is acceptably retained while stress is usefully reduced compared with the properties of the bulk, individual hard layer.

Depositing alternate first and second layers may be achieved by varying the CVA process between hard, first layer parameter and those of the soft, second layer, especially by
(a) depositing the first layer using a CVA process at a first bias voltage;
(b) depositing the second layer using a CVA process at a second bias voltage more negative than the first.

Softer layers can be deposited at the higher negative bias, and suitably the second bias voltage is at least 100V more negative that the first bias voltage or at least 200V more negative than the first bias voltage, preferably at least 300V more negative. The difference may also be greater e.g. dependent upon the nature of the substrate and can be 500V or more, or 800V or more.

FCVA deposition of hard ta-C films is an established process, and again, while biasing can be substrate dependent, the first bias voltage is generally in the range from -100V to -1000V, more commonly -100V to -800V; the second bias voltage is generally in the range from -500V or -600V to -1000V or -1600V, more commonly -600V or -700V to -1000V or -1200V. In methods operated in examples below and in embodiments of the invention the negative change in bias softens the coating and is used to deposit the thin intermediate, soft layer to reduce overall coating stress without overly compromising hardness.

Biasing is generally in accordance with a duty cycle, e.g. via a substantially square wave pattern, 100% indicating the bias is constant and generally operating with a duty cycle of 70% or below, such from 2% to 70%, usually DC and pulsed, and more commonly 5% to 50%. In a specific embodiment described below in more detail, to deposit the second layer, the soft TAC layer, the substrate was biased at about -900V, with a 40% duty cycle using a 44KHz pulsed DC power supply. The duty cycles for the respective layers can theoretically be the same, if biasing differences are highly significant, hence only the biasing changes between harder and softer layers, though normally for the hard layers the duty cycle is from 3 to 20% and for the soft layers is from 20 to 50%. Generally, the duty cycle increases for depositing the second, soft layers, increasing say 10% or 20% or 30% or more.

The inventors of the present application have accordingly found that by varying the bias on the substrate to be coated, and optionally the duty cycle, cathodic vacuum arc (CVA) processes can be used to deposit both harder coatings and softer coatings in the same operation. This can achieve a coating comparable to and improved compared to the coating described in WO 2009/151404 in that the softer layers are found to reduce stress in the coating, whilst the harder layers impart their hardness to the coating, which property is largely retained despite the presence of the thin, softer layers.

To retain hardness in the coating it is preferred that the second, softer layers are of significantly reduced thickness compared with the harder, first layers. In illustrative examples of the invention first layers of approximately 300nm - 600nm were alternated with second layers of approximately 0.5nm - 3nm, and in a specific embodiment set out below first layers of approx. 500nm were alternated with second layers of 1nm - 2nm. If the second layers are overly thick then not only the low stress properties of those layers but also their reduced hardness may begin to dominate the overall coating properties. In general, the first layer thickness is 100nm or greater, suitably 200nm or greater, and may be up to 1500nm, suitably up to 1000nm, especially up to 600nm or 800nm. The second layers are notably thinner and are suitably 10nm or less, suitably 5nm or less and preferably 3nm or less, or 2nm or less, and around 2nm or around 1nm in specific embodiments. To provide stress reduction there is preferably sufficient of the softer, low stress component and the second layers should preferably be at least 0.5nm thick or at least 1nm thick. CVA process, especially FCVA process, are used, and these are capable of producing uniform, dense and smooth layers of these orders of thickness; the same is generally not true of sputter type processes which cannot at present produce smooth coatings down to these smaller thicknesses.

The layers combine to form coatings and as will be appreciated from the above the ratio of the first thickness to second thickness is generally from 4000:1 to 5:1, more commonly from 1000:1 to 50:1 and preferably from 500:1 to 150:1. The layers can be built up into thicknesses not achievable using the bulk material, and typical coatings of the invention comprising many layers have a total thickness from 1 - 100 microns, from 2 microns and thicker, from 3 microns and thicker from 5 microns and thicker. Coatings entirely of hard ta-C are particularly brittle when of higher thickness and further embodiments of the invention that illustrate advantage comprise coatings of thickness 10 microns and higher, and 15 microns and higher, especially up to 50 microns or up to 60 microns. Specific examples described below were of approximately 15 microns, 26 microns and 30 microns, all showing good hardness and/or critical loads values in testing.

As is conventional in this field, a seed layer and/or an adhesion layer are usually deposited onto the substrate prior to depositing the ta-C layers. Seed layers can improve adhesion of the ta-C coatings (e.g. by providing bonding between the substrate and the further deposited layers). Seed layers may also provide modulus matching between the substrate and the working coating. Examples of suitable seed layers include conducting seed layers, especially if the substrate is non-conducting without the seed layer. Seed layers can thus impart conductivity to the substrate when ta-C is coated onto nonconductive substrates. Using a seed layer hence enables deposition of coatings on ceramics, as an example. As examples of seed materials are Ti, Cr, NiCr, WCr and combinations thereof. Use of seed layers is known in the coatings art and use of the seed and choice of seed material is not part of the present invention.

The invention further provides a substrate comprising a coating deposited according to the method of the invention. These substrates and their coatings are typically characterised as per the optional and preferred features and parameters of the invention discussed above and below. By way of example, preferred substrates comprise coatings having a thickness of 1 - 100 microns, more preferably preferably 3 - 60 microns, with alternating first layers of thickness 100nm - 800nm and second layers of 0.5nm to 3nm. Preferred substrates preferably comprise coatings with a Vickers hardness of 2000HV or greater, e.g. 2500 HV or greater, more preferably 2800 HV or greater, or 3500 HV or harder, and can have hardness up to 4000HV or 5000HV.

In general, the substrate choice is not a particular feature of the invention. Conventional CVA and FCVA processes are known and used for a wide range of substrates and the methods of the invention are similarly suitable for coating a wide range of substrates. Solids, both conducting and non-conducting, are generally suitable and seed layers and adhesion layers can be used to improve coating adhesion and strength, and to render surfaces amenable to being coated. Substrates made of metal, alloy, ceramics and mixtures thereof can be coated. Metal and composite substrates can be coated, especially steel and varieties of steel as well as and parts, tools, components etc made thereof. Specific examples of preferred substrates include electrodes, e.g. for use in fuel cell or electrochemical applications. Other preferred substrates include tools, tooling, industrial machines and components therefor. It is further and separately preferred that the substrate is an engine component, such as a piston ring, a piston pin, a cam shaft, a lift valve or an injection nozzle.

The CVA process is typically a filtered cathodic vacuum arc (FCVA) process, e.g. as used in the examples. Apparatus and methods for FCVA coatings are known and can be used as part of the methods of the invention. The FCVA coating apparatus typically comprises a vacuum chamber, an anode, a cathode assembly for generating plasma from a target and a power supply for biasing the substrate to a given voltage. The nature of the FCVA is conventional and not a part of the invention.

Hardness is suitably measured using the Vickers hardness test (developed in 1921 by Robert L. Smith and George E. Sandland at Vickers Ltd), which can be used for all metals and has one of the widest scales among hardness tests. The unit of hardness given by the test is known as the Vickers Pyramid Number (HV) and can be converted into units of pascals (Gpa). The hardness number is determined by the load over the surface area of the indentation used in the testing. As examples. Martensite a hard form of steel has HV of around 1000 and diamond can have a HV of around 10,000 HV (around 98 GPa). Hardness of diamond can vary according to precise crystal structure and orientation but hardness of from about 90 to in excess of 100 GPa is common.

Again, and as also discussed elsewhere herein, the overall properties of the composite coating are influenced by the alternating harder, thick layers and thin, softer layers. As shown in examples below, an advantage of the invention is that using the method it is possible to yield coatings with comparable stress to those of the prior art (e.g. WO 2009/151404) yet increased hardness. In a specific example, a coating of the invention showed significantly improved hardness over one of the prior art, exhibiting nearly 50% increase in hardness measured by Vickers number. In other testing of examples of the invention coating performance was good, coatings exhibiting *inter alia* increased critical load compared with examples of the prior art.

As a further and separate advantage, coatings of the invention can be made in a chamber while operating just a single source of depositing layer. Methods of the invention preferably comprise carrying out the deposition using a substantially continuous CVA process for the first and second layers using the same CVA source, preferably a FCVA source. This allows a process not interrupted or otherwise affected by switching between (i) FCVA and (ii) sputter sources. In a chamber with a given number (>1) of stations for location of a source, this frees up one station for an alternative source, e.g. different type of source, different material etc, hence increasing the options available within the apparatus. Instead of a sputter source, in a 2-source chamber a CVA source for applying a seed layer can be provided. The invention also simplifies the coating equipment needed to deposit these thick, hard coatings - e.g. apparatus with a single source can be used.

An additional advantage of coatings of the invention is they can demonstrate increased working temperature, because of the absence of a more temperature sensitive sputtered layer in the coating.

The invention is now illustrated with reference to the accompanying drawings, in which:-
Fig. 1 shows hardness result for a coating made in accordance with WO 2009/151404;
Fig. 2 shows hardness result for a coating made in accordance with the invention and set out in Example 2;
Fig. 3 shows an SEM of the coating made in accordance with WO 2009/151404 after temperature testing;
Fig. 4 shows an SEM of the coating of Example 2 after temperature testing;
Fig. 5 shows an SEM of a further coating of the invention with thickness approx. 30 microns;
Fig 6 (a, b) shows the coating of fig. 5 prior to temperature testing;
Fig 7(a, b, c, d) shows the coating of fig. 5 after temperature testing;
Fig. 8 (a, b) shows the coating of example 4 after temperature testing;
Fig. 9 shows an SEM of a further coating of the invention with thickness approx. 13 microns; and
Fig. 10 shows the loading/unloading curve for the coating of fig. 9 as used to calculate its hardness.

### Example 1 - Comparative Example

Following the teaching of WO 2009/151403, example 3, a ta-C coating was prepared on a HSS piston ring having the following parameters:

| | |
|---|---|
| Seed layer | Ti, approx. 250nm |
| FCVA layers | approx. 350nm |
| Sputtered layers | approx. 10nm |
| Total coating thickness | approx. 20 microns |

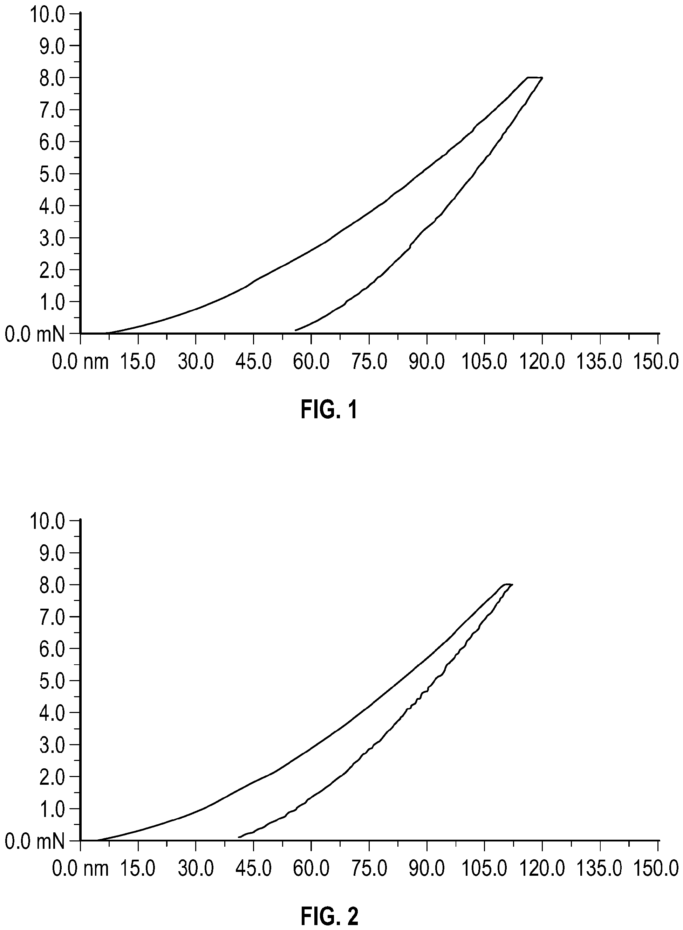

Nanohardness was tested at a maximum loading of 8mN, loading speed 16mM/min, holding time 30s. The results are shown in fig. 1 and gave a calculated hardness of 2211HV. Critical load was not determined, though in all embodiments of example 3 from WO 2009/151403 the critical load values varied in the range approx. 18-21N.

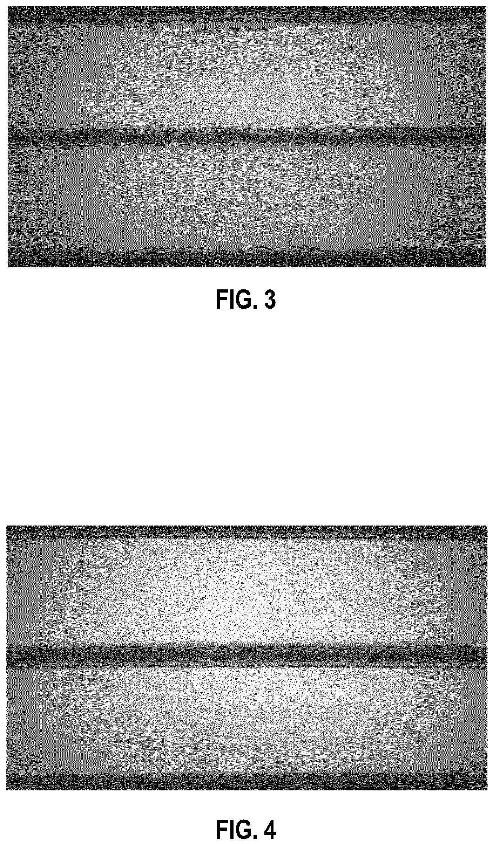

Temperature resistance was measured by holding the piston ring at 400°C for 2 hours, the cooled ring after the test being shown in fig. 3, with minor delamination / surface damage being seen, indicating a fail of this test.

### Example 2

A coating of the invention was prepared to match the coating of the prior art as per example 1, again with ta-C coated onto a HSS piston ring, the coating having the following parameters:

| | |
|---|---|
| Seed layer | Ti, approx. 250nm |
| FCVA hard layers | approx. 500nm |
| FCVA soft layers | approx. 1-2nm |
| Total coating thickness | approx. 20 microns |

The coating was deposited with alternate first (hard) and second (soft) layers, via FCVA the soft layers deposited with negative bias of approximately -900V, with a 40% duty cycle using a 44KHz pulsed DC power supply. Biasing for the first layers was standard for hard ta-C layer deposition, being approximately -200V, duty cycle 30%.

Nanohardness was tested at a maximum loading of 8mN, loading speed 16mM/min, holding time 30s. The results are shown in fig. 2 and gave a calculated hardness of 3122HV. Critical load was not determined. Temperature resistance was similarly measured by holding the piston ring at 400°C for 2 hours, the cooled ring after the test being shown in fig. 3, with absence of delamination and surface damage indicating a pass of this test.

### Example 3

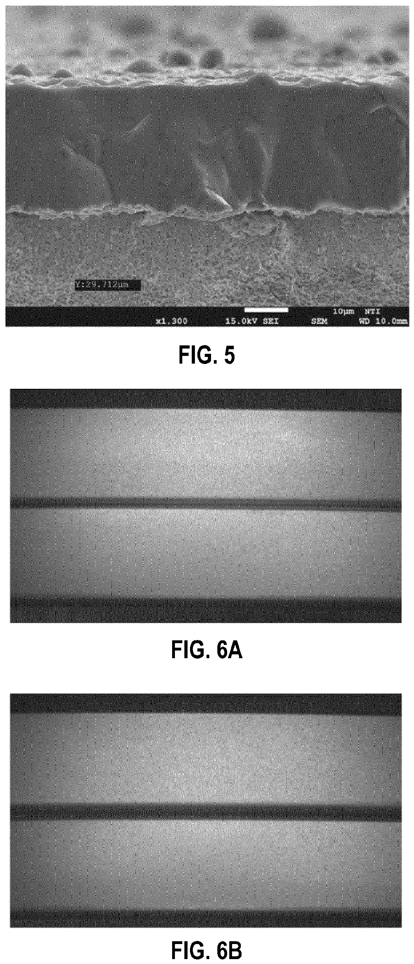

A HSS Shuang Huan piston ring was coated with approx. 60 repeating layers of approx. 500nm hard ta-C (bias approximately -200V) and approx. 1-2nm layers of soft ta-C (bias approx. -1000V). The finished coating thickness was measured by SEM cross-sectional analysis (and one such cross section is shown in Fig. 5); three separate measurements gave thicknesses of 29.71 microns, 29.73 microns and 29.9 microns, hence a smooth, substantially uniform coating with thickness approx. 30 microns was achieved.

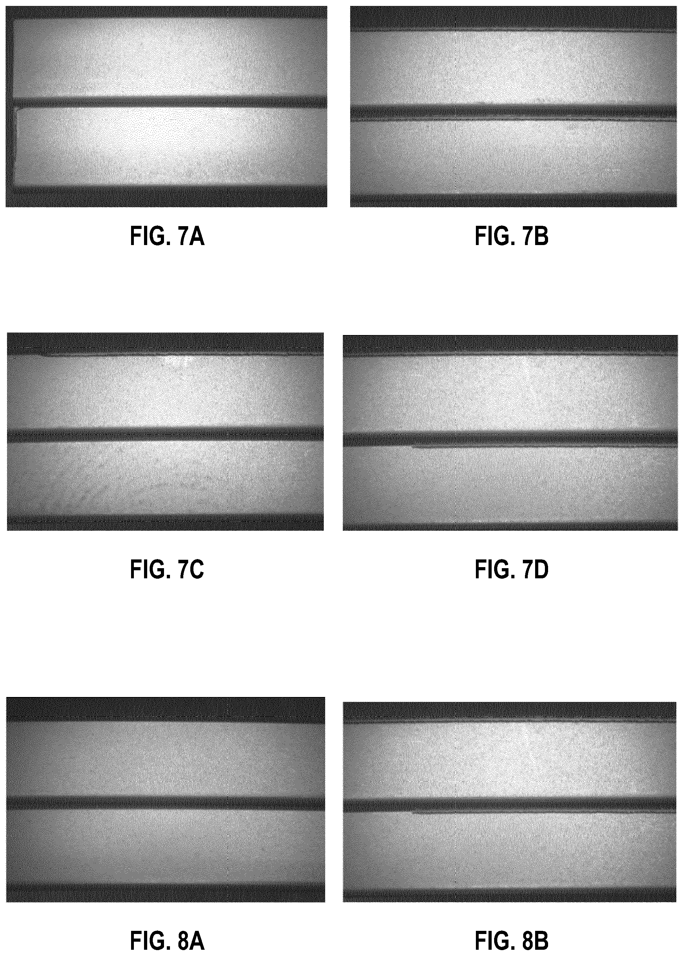

The coated piston ring was subjected to temperature testing, with samples analyzed prior to heating (Fig. 6a, b) and after 2 hours heating at 400°C (Fig. 7a, b, c and d). The coating is seen to have passed this heating test.

The coating was subjected to a first scratch test with a max load of 60N, and passed. The coating was subjected to a second scratch test with a max load of 100N and demonstrated critical load failure at approx. 80N.

### Example 4

A HSS diesel engine piston ring was coated with approx. 50 layers of hard ta-C (substrate bias approx. -300V) with soft ta-C layers of approx. 1-2nm (bias -1000V) giving a coating thickness of approx. 25 microns measured by SEM cross-sectioning.

The coating was subjected to the same temperature test as in Example 3, with the coating post-testing shown in Fig. 8 (a, b). After heating and cooling there was no delamination of the coating from the piston ring indicating the coating had good thermal stability and good adhesion onto the substrate, and passed the test.

Coating hardness was tested with a maximum load of 8mN with a load/unload rate of 16mN/min with 30s holding time. The hardness was calculated as approx. 2500HV.

Wear evaluation was carried out using a ball crater machine, with a ball rotation speed of 300rpm, ball diameter 30mm, sample slope angle of 25° and lapping slurry (with 0.1 micron diameter diamond powder) applied during testing. After 30 minutes of the wear test the crater depth was 3.56 microns and the crater diameter was 743 microns. After 120 minutes of the wear test the crater depth was 7.25 microns and the crater diameter 1019 microns.

The coating was subjected to a scratch test with an Anton Paar revertest scratch tester having a diamond indenter/stylus with a spherical tip of radius 200 microns and a Rockwell C geometry with an angle of 120°, load speed of 40N/min. With a 60N scratch load there was no cracking in the coating, indicating the critical load of the coating is in excess of 60N.

The coating was subjected to a separate anti-wear performance evaluation, measuring wear of the coated piston ring in response to reciprocation of the piston ring on a cylinder liner. Using a load force between the piston ring and the liner of 500N, a reciprocating frequency of 4Hz, with engine lubricant/oil applied between the interface of the piston ring and the cylinder liner, the test was continued for 230,400 cycles (3cm per cycle), amounting to approx. 16 hours of test duration. After the test, the coating was investigated by microscopy and a stylus profiler. The wear track depth was measured as less that 0.2 microns, indicating very low wear for this test.

The coating was separately subjected to a co-efficient of friction test using a Tribo-tester (Bruker® Tribolab system, Bruker Corporation). Friction between the piston ring and a cylinder liner was measured with and without lubricant oil (Castrol® engine oil, 5w-30) with a normal force between the ring and the liner of 10N and a pin with velocity 0.84mm/sec (0.03Hz, 14mm stroke). With lubrication the coefficient of friction (COF) was measured as 0.04-0.14 and without oil the COF was measured as 0.15-0.18.

### Example 5

A HSS piston ring was coated according to example 4, though with reduced number of coating layers, yielding a coating of approx. 13 microns thickness.

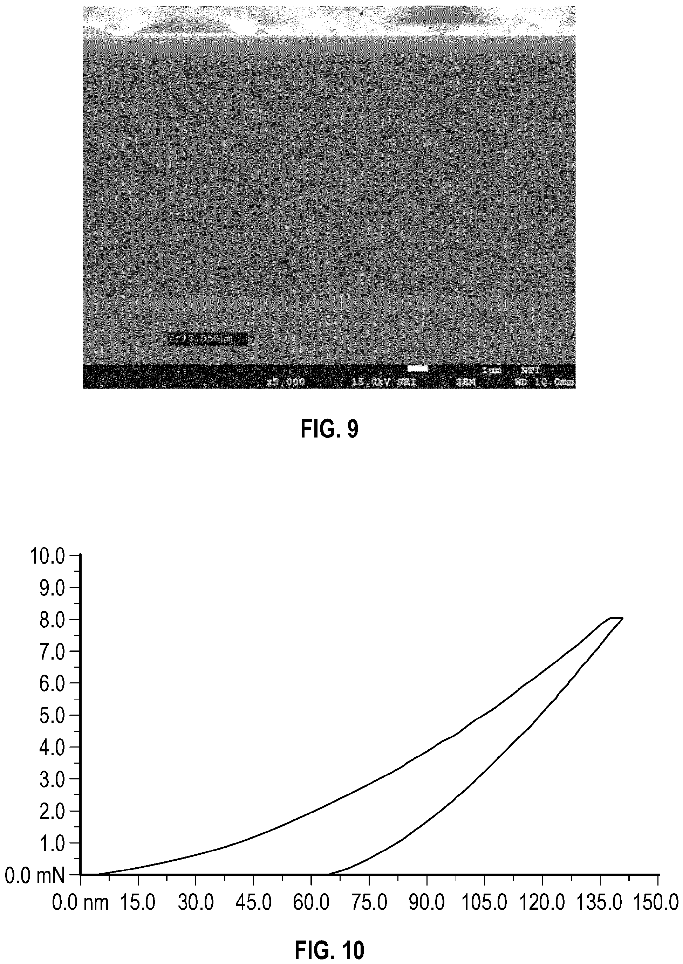

SEM cross-sectional analysis showed a dense, uniform coating (see Fig. 9).

Coating hardness was measured using a nanoindenter with a maximum load of 8mN, a load/unload rate of 16mN/min with 30s holding time. The loading/unloading curve is shown in Fig. 10, giving a hardness calculated as 2850HV.

The coating was subjected to a Taber abrasion test (TLA 5700) with abradant CS-17, a test load of 1.5kg and a cycle speed of 60 cycles/min with a stroke length of 50mm. After 70,000 cycles the coating remained intact, and hence passed the test.

Accordingly, the present invention provides methods for making a ta-C coating and substrates coated therewith.

## Claims

1. A method of depositing a coating on a substrate, the method comprising:
(a) depositing a first layer of ta-C on a substrate via a CVA process, said first layer having a first hardness and a first thickness;
(b) depositing a second layer of ta-C on a substrate via a CVA process, said second layer having a second hardness and a second thickness, and
(c) repeating step (a) at least once,
wherein the first thickness is greater than the second thickness and the first hardness is greater than the second hardness.

2. A method of depositing a coating on a substrate, the method comprising:
(a) depositing a first layer of ta-C on a substrate via a CVA process, said process carried out using deposition parameters to deposit a first layer having a first hardness and a first thickness;
(b) adjusting the parameters of the CVA deposition process to deposit onto the first layer a second layer of ta-C having reduced hardness and reduced thickness;
(c) repeating step (a) at least once.

3. A method according to any of claims 1 to 2, comprising continuously depositing the coating on the substrate and repeating the steps to provide a coating comprising at least 5 such first layers and at least 4 such second layers.

4. A method according to any previous claim, comprising carrying out the deposition using a substantially continuous CVA process for the first and second layers using the same CVA source, preferably a FCVA source.

5. A method according to any previous claim, comprising
(a) depositing the first layer using a CVA process at a first bias voltage;
(b) depositing the second layer using a CVA process at a second bias voltage more negative than the first.

6. A method according to claim 5, wherein the first bias voltage is from -100V to - 800V.

7. A method according to claims 5 or 6, wherein the second bias voltage is at least 200V more negative than the first bias voltage.

8. A method according to claim 5, 6 or 7, wherein the second bias voltage is from - 600V to -1200V.

9. A method according to any previous claim, wherein said second thickness is 5nm or less.

10. A method according to any previous claim, wherein said first thickness is 200nm or greater.

11. A method according to any previous claim, wherein the ratio of the first thickness to second thickness is from 1000:1 - 50:1.

12. A method according to any previous claim, wherein the total thickness of the coating is from 1 - 100 microns.

13. A substrate comprising a coating deposited according to the method of any of claims 1 to 12.

14. A substrate according to claim 13, wherein the hardness of the coating is 2000 HV or greater.

15. A substrate according to any of claims 13 to 14, wherein the substrate is an engine component, e.g. a piston ring, a piston pin, a cam shaft, a lift valve or an injection nozzle.
